# EUROPEAN PATENT SPECIFICATION

(11) **EP 0 969 326 B1**
(45) Date of publication and mention of the grant of the patent: **17.10.2012**
(21) Application number: 99304779.4
(22) Date of filing: 18.06.1999
(51) Int. Cl.: G03F 7/20

(54) **Lithographic apparatus**
Lithographischer Apparat
Appareil lithographique

(30) Priority: 01.07.1998 EP 98202190
(43) Date of publication of application: 05.01.2000
(73) Proprietor: ASML Netherlands B.V., 5504 DR Veldhoven (NL)
(72) Inventor: Bleeker, Arno Jan, 5615 LK Eindhoven (NL)
(74) Representative: Weenink, Willem

(56) References cited:
- WO-A-93/00614
- JP-A- 9 074 064
- JP-A- 10 079 346
- US-A- 5 437 946
- US-A- 5 486 896
- US-A- 5 719 617

## Description

The present invention relates to a manner of control of the illumination system in a lithographic apparatus. More particularly, the invention relates to the control of the illumination system in lithographic projection apparatus comprising:
a radiation system comprising a radiation source and an illumination system for supplying a projection beam of radiation;
a first movable object table provided with a mask holder for holding a mask;
a second movable object table provided with a substrate holder for holding a substrate; and
a projection system for imaging an irradiated portion of the mask onto a target portion of the substrate.

For the sake of simplicity, the projection system may hereinafter be referred to as the "lens"; however, this term should be broadly interpreted as encompassing various types of projection system, including refractive optics, reflective optics, catadioptric systems, and charged particle optics, for example. The illumination system may also include elements operating according to any of these principles for directing, shaping or controlling the projection beam of radiation, and such elements may also be referred to below, collectively or singularly, as a "lens". In addition, the first and second object tables may be referred to as the "mask table" and the "substrate table", respectively. Further, the lithographic apparatus may be of a type having two or more mask tables and/or two or more substrate tables. In such "multiple stage" devices the additional tables may be used in parallel, or preparatory steps may be carried out on one or more stages while one or more other stages are being used for exposures. Twin stage lithographic apparatus are described in International Patent Applications WO 98/28665 and WO 98/40791, for example.

Lithographic projection apparatus can be used, for example, in the manufacture of integrated circuits (ICs). In such a case, the mask (reticle) may contain a circuit pattern corresponding to an individual layer of the IC, and this pattern can be imaged onto a target area (die) on a substrate (silicon wafer) which has been coated with a layer of photosensitive material (resist). In general, a single wafer will contain a whole network of adjacent dies which are successively irradiated via the reticle, one at a time. In one type of lithographic projection apparatus, each die is irradiated by exposing the entire reticle pattern onto the die in one go; such an apparatus is commonly referred to as a wafer stepper. In an alternative apparatus - which is commonly referred to as a step-and-scan apparatus - each die is irradiated by progressively scanning the reticle pattern under the projection beam in a given reference direction (the "scanning" direction) while synchronously scanning the wafer table parallel or anti-parallel to this direction; since, in general, the projection system will have a magnification factor M (generally < 1), the speed v at which the wafer table is scanned will be a factor M times that at which the reticle table is scanned. More information with regard to lithographic devices as here described can be gleaned from International Patent Application WO 97/33205.

In a lithographic apparatus, the size of features that can be imaged onto the wafer is limited by the wavelength of the projection radiation. To produce integrated circuits with a higher density of devices and hence higher operating speeds, it is desirable to be able to image smaller features. Whilst most current lithographic projection apparatus employ ultraviolet light generated by mercury lamps or excimer lasers, it has been proposed to use higher frequency (energy) radiation, e.g. EUV or X-rays, or particle beams, e.g. electrons or ions, as the illumination radiation in lithographic apparatus.

However, the glass or quartz plates on which a conventional reticle pattern is defined are generally not transparent to some of these forms of illumination radiation. As an alternative in the case of charged-particle lithography, for example, the reticle is formed of a material, e.g. metal, that is opaque to the form of radiation used and in which apertures are cut to define the reticle pattern. To avoid the need to provide obscuring support arms to opaque islands in the pattern, the reticle pattern is divided into a plurality of sub-patterns separated by supporting struts. The complete pattern is correctly imaged on the wafer by introducing successive shifts in the illumination beam after it has passed through each sub-pattern. This type of arrangement is sometimes referred to as a "strutted mask" and an example is disclosed in US 5,079,112.

General information with regard to the use of electron beams in lithography can be gleaned, for example, from US 5,260,151.

As disclosed in EIPBN, May 1998 AE6, "Critical dimension control at stitched sub-field boundaries in a high-throughput SCALPEL system", if the beam intensity profile of the illumination radiation is rectangular, then any positional inaccuracy in the stitching process will result in a substantial dose error. Such a stitching procedure using rectangular beam profiles is sometimes referred to as "simply-butted" and if the beam positions are not accurate there will be a region of no dose or double dose along the stitch seams. The EIPBN article therefore proposes the use of a trapezoidal beam profile and deliberate overlap in the stitching process. Positional inaccuracies then result in smaller dose errors.

The EIPBN article does not, however, disclose any method for generating an illumination beam having the desired trapezoidal intensity profile.

Patent Abstracts of Japan relating to JP-A-09-074,064 discloses a lithographic projection apparatus using charged particle beams in which the mask comprises an array of square sub-fields.

Patent Abstracts of Japan relating to JP-A-10-079,346 also discloses a lithographic projection apparatus using electron beams in which the mask is divided into small square regions.

An object of the present invention is to provide a convenient means of generating an illumination beam having a trapezoidal intensity profile in a lithographic projection apparatus.

According to the present invention there is provided a lithographic projection as defined in the appended claims.

The term "transmissive region" is intended to refer to a region of the mask which is at least substantially transparent to the illumination radiation used.

With the present invention it is possible to easily generate the desired beam profile using electronic control of the beam size or position.

According to a yet further aspect of the invention there is provided a method of manufacturing a device using a lithographic projection apparatus as defined in the appended claims.

In a manufacturing process using a lithographic projection apparatus according to the invention a pattern in a mask is imaged onto a substrate which is at least partially covered by a layer of energy-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallisation, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target area", respectively.

In the present document, the terms illumination radiation and illumination beam are used to encompass all types of charged particle flux, including, but not limited to, electrons and ions.

The present invention will be described below with reference to exemplary embodiments and the accompanying schematic drawings, in which:
Figure 1 depicts a lithographic projection apparatus according to a first embodiment of the invention;
Figure 2 is a plan view of a strutted reticle showing the scanning directions that may be used in embodiments of the invention;
Figure 3 illustrates the overlap between beams in a stitching process;
Figures 4A to C illustrate the stitching process and resultant dose in the cases of correct and incorrect beam positioning;and
Figure 5 is a partial view of a reticle illustrating the manner of generation of the beam profile according to a first embodiment of the invention.

In the drawings, like reference numerals indicate like parts.

### Embodiment 1

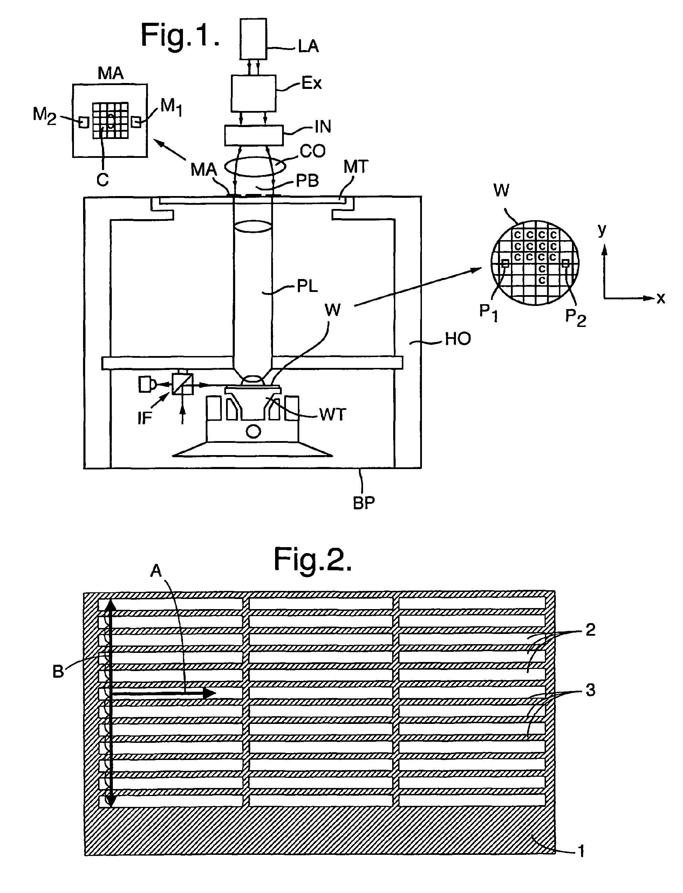

Figure 1 schematically depicts a lithographic projection apparatus according to the invention. The apparatus comprises:
- a radiation system LA, Ex, IN, CO for supplying a projection beam PB of radiation (*e.g*. UV or EUV radiation);
- a first object table (mask table) MT provided with a mask holder for holding a mask MA (*e.g*. a reticle), and connected to first positioning means for accurately positioning the mask with respect to item PL;
- a second object table (substrate table) WT provided with a substrate holder for holding a substrate W (*e.g.* a resist-coated silicon wafer), and connected to second positioning means for accurately positioning the substrate with respect to item PL;
- a projection system ("lens") PL (*e.g.* a refractive or catadioptric system, a mirror group or an array of field deflectors) for imaging an irradiated portion of the mask MA onto a target portion C (die) of the substrate W.

As here depicted, the apparatus is of a transmissive type (i.e. has a transmissive mask). However, in general, it may also be of a reflective type, for example.

The radiation system comprises a source LA (*e.g.* a Hg lamp, excimer laser, an undulator provided around the path of an electron beam in a storage ring or synchrotron, or an electron or ion beam source) which produces a beam of radiation. This beam is passed along various optical components comprised in the illumination system, - *e.g.* beam shaping optics Ex, an integrator IN and a condenser CO - so that the resultant beam PB is substantially collimated and uniformly intense throughout its cross-section.

The beam PB subsequently intercepts the mask MA which is held in a mask holder on a mask table MT. Having passed through the mask MA, the beam PB passes through the lens PL, which focuses the beam PB onto a target area C of the substrate W.

With the aid of the interferometric displacement and measuring means IF, the substrate table WT can be moved accurately, *e.g.* so as to position different target areas C in the path of the beam PB. Similarly, the first positioning means can be used to accurately position the mask MA with respect to the path of the beam PB, *e.g.* after mechanical retrieval of the mask MA from a mask library. In general, movement of the object tables MT, WT will be realized with the aid of a long stroke module (course positioning) and a short stroke module (fine positioning), which are not explicitly depicted in Figure 1. The depicted apparatus can be used in two different modes:
- In step mode, the mask table MT is kept essentially stationary, and an entire mask image is projected in one go (*i.e.* a single "flash") onto a target area C. The substrate table WT is then shifted in the x and/or y directions so that a different target area C can be irradiated by the beam PB;
- In scan mode, essentially the same scenario applies, except that a given target area C is not exposed in a single "flash". Instead, the mask table MT is movable in a given direction (the so-called "scan direction", *e.g.* the x direction) with a speed v, so that the projection beam PB is caused to scan over a mask image; concurrently, the substrate table WT is simultaneously moved in the same or opposite direction at a speed *V* = *Mv,* in which *M* is the magnification of the lens PL (typically, *M* = 1/4 or 1/5). In this manner, a relatively large target area C can be exposed, without having to compromise on resolution.

Figure 2 shows a reticle in plan and the scheme by which it can be scanned with an illumination beam. As shown, the reticle 1 comprises an array of elongate sub-fields 2 (e.g. of length 12mm) separated by struts 3. The reticle is illuminated by, e.g., a square beam of 1 x 1mm² size. The beam must illuminate each sub-field for a sufficient period to deliver a dose to expose the resist on the substrate wafer. By way of an example, if the resist sensitivity is 10µC/cm², the beam current 10µA and the magnification 1/4 then the time required to expose each (sub-) field is 625µs.

The scanning scheme used, which is known in the prior art, is to scan across the widths of the sub-fields in the direction of arrow B, stepping across the struts to avoid excessive heating, and to mechanically scan the wafer and reticle along the lengths of the sub-fields, in the direction of arrow A (mutually parallel or anti-parallel).

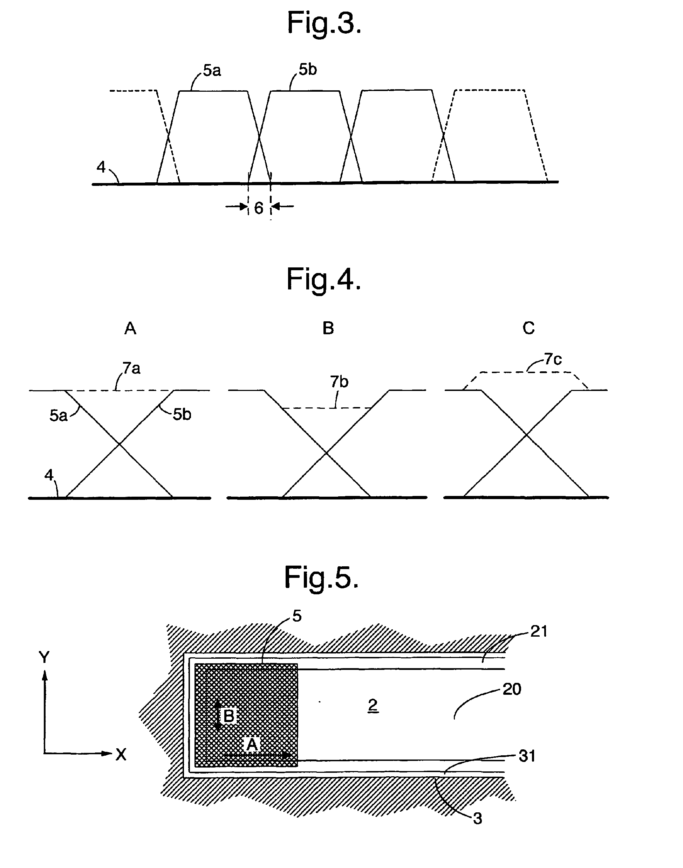

As shown in Figure 3, the beams 5a and 5b used to scan adjacent sub-fields 2 have trapezoidal (intensity) profiles. In the stitching process, the beams 5a, 5b are shifted sideways so that they overlap on the wafer 4 in region 6. As shown in Figure 4A, if the beams are correctly positioned then the net radiation dose 7a in the overlap region 6 is equal to that in the main beam portion.

The effects of small misalignments are shown in Figure 4B and 4C. If the beams are slightly too far apart, then the net dose is slightly reduced in the overlap region, as shown by dashed line 7b. If the beams overlap too much, then the net dose is slightly increased, as shown by dashed line 7c. The slight under or over dose in either case is not as detrimental as the double dose or no dose that occurs in the event of misalignment when using a simply-butted stitching technique.

Figure 5 is a partial view of one mask sub-field and illustrates how the desired beam profile is achieved according to one embodiment of the invention.

The sub-field 2 is surrounded by the strut 3 and has around its edge a blending area 21, the pattern of which is repeated in the blending area of the adjacent sub-field. The inside edge of the strut 3 is provided with a skirt 31 which has no pattern on it.

The illumination system (not shown) projects a square illumination beam 5 of uniform-intensity illumination radiation on to the sub-field 2. The illumination beam 5 is arranged to be equal in width (in the Y-direction) to the main sub-field portion 20 plus the width of one side of the blending area 21. Thus the illumination beam is smaller than the distance between the skirts 31 of the struts 3.

The desired trapezoidal beam profile is achieved according to the invention by scanning the beam rapidly within the sub-field in the direction of arrow B, i.e. perpendicular to the length of the sub-field 2. The illumination profile shown in Figure 3 is thus built up as the sum of a plurality of scans back and forth in direction B.

A trapezoidal profile along the longitudinal direction of the sub-field is also necessary if the beam is stepped in that direction, and this is achieved by effecting a movement in the direction of arrow A (i.e. along the length of the sub-field) that is much slower than that in the direction of arrow B.

Whilst we have described above a specific embodiment of the invention it will be appreciated that the invention may be practiced otherwise than described. The description is not intended to limit the invention.

## Claims

1. A lithographic projection apparatus for imaging of a mask pattern in a mask onto a substrate provided with a radiation sensitive layer, the mask having a plurality of elongate transmissive regions (2) bounded by opaque regions (3), the apparatus comprising:
a radiation system comprising a radiation source (LA) and an illumination system (IL) for generating an illumination beam comprising charged particles;
a first movable object table (MT) provided with a mask holder for holding a mask;
a second movable object table (WT) provided with a substrate holder for holding a substrate;
positioning means for scanning the mask and substrate in the longitudinal direction of the transmissive regions during the course of the exposure period thereof;
and
a projection system (PL) for imaging irradiated portions of the mask onto target portions of the substrate; **characterised in that**:
said illumination system is embodied to generate an illumination beam having a width less than the width of the transmissive region to be illuminated, and to scan said illumination beam across the width of said transmissive region a plurality of times during the course of the exposure period so as to generate an effective trapezoidal beam intensity profile.

2. A method of manufacturing a device using a lithographic projection apparatus to project an image of a mask having a plurality of elongate transmissive regions (2) bounded by opaque regions (3), the apparatus comprising:
a radiation system comprising a radiation source (LA) and an illumination (IL) for generating an illumination beam;
a first movable object table (MT) provided with a mask holder for holding a mask (M)
a second movable object table (WT) provided with a substrate holder for holding a substrate (W);
positioning means for scanning the mask and substrate in the longitudinal direction of the transmissive regions during the course of the exposure period thereof;
a projection system (PL) for imaging a irradiated portions of the mask onto target portions of the substrate provided with a radiation-sensitive layer, so as to partially overlap; **characterised by** the steps of
generating an illumination beam having a width less than the width of the transmissive region to be illuminated; and
scanning the illumination beam across the width of said transmissive region during the course of an exposure period thereof whilst scanning the mask and substrate in the longitudinal direction of the transmissive region so as to generate an effective trapezoidal beam intensity profile.

## Patentansprüche

1. Ein lithographisches Projektionsgerät zum Abbilden eines Maskenmusters in einer Maske auf einem mit einer strahlungsempfindlichen Schicht versehenen Substrat, wobei die Maske eine Vielzahl von länglichen durchlässigen Bereichen (2), die durch opake Bereiche (3) begrenzt sind, aufweist, wobei das Gerät Folgendes beinhaltet:
ein Strahlungssystem, das eine Strahlungsquelle (LA) und ein Beleuchtungssystem (IL) zum Erzeugen eines Beleuchtungsstrahls, welcher geladene Teilchen beinhaltet,
beinhaltet;
einen ersten bewegbaren Objekttisch (MT), der mit einem Maskenhalter zum Halten einer Maske versehen ist;
einen zweiten bewegbaren Objekttisch (WT), der mit einem Substrathalter zum Halten eines Substrats versehen ist;
Positionierungsmittel zum rasterförmigen Führen der Maske und des Substrats in der Längsrichtung der durchlässigen Bereiche während des Verlaufs der Belichtungszeit davon; und
ein Projektionssystem (PL) zum Abbilden bestrahlter Abschnitte der Maske auf Zielabschnitten des Substrats; **dadurch gekennzeichnet, dass**:
das Beleuchtungssystem ausgeführt ist, um einen Beleuchtungsstrahl mit einer Breite, die geringer als die Breite des zu beleuchtenden durchlässigen Bereichs ist, zu erzeugen, und um den Beleuchtungsstrahl mehrere Male während des Verlaufs der Belichtungszeit rasterförmig über die Breite des durchlässigen Bereichs zu führen, um ein effektives trapezförmiges Strahlintensitätsprofil zu erzeugen.

2. Ein Verfahren zum Herstellen einer Vorrichtung unter Verwendung eines lithographischen Projektionsgeräts, um ein Bild einer Maske mit einer Vielzahl von länglichen durchlässigen Bereichen (2), die durch opake Bereiche (3) begrenzt sind, zu projizieren, wobei das Gerät Folgendes beinhaltet:
ein Strahlungssystem, das eine Strahlungsquelle (LA) und eine Beleuchtung (IL) zum Erzeugen eines Beleuchtungsstrahls beinhaltet;
einen ersten bewegbaren Objekttisch (MT), der mit einem Maskenhalter zum Halten einer Maske (M) versehen ist;
einen zweiten bewegbaren Objekttisch (WT), der mit einem Substrathalter zum Halten eines Substrats (W) versehen ist;
Positionierungsmittel zum rasterförmigen Führen der Maske und des Substrats in der Längsrichtung der durchlässigen Bereiche während des Verlaufs der Belichtungszeit davon;
ein Projektionssystem (PL) zum Abbilden eines bestrahlter Abschnitte der Maske auf Zielabschnitten des mit einer strahlungsempfindlichen Schicht versehenen Substrats,
so dass sie teilweise überlappen; **gekennzeichnet durch** folgende Schritte:
Erzeugen eines Beleuchtungsstrahls mit einer Breite, die geringer als die Breite des zu beleuchtenden durchlässigen Bereichs ist; und
rasterförmiges Führen des Beleuchtungsstrahls über die Breite des durchlässigen Bereichs während des Verlaufs einer Belichtungszeit davon, während die Maske und
das Substrat in der Längsrichtung des durchlässigen Bereichs rasterförmig geführt werden, um ein effektives trapezförmiges Strahlintensitätsprofil zu erzeugen.

## Revendications

1. Un appareil de projection lithographique destiné à reporter l'image d'un motif de masque dans un masque sur un substrat pourvu d'une couche sensible à un rayonnement, le masque ayant une pluralité de régions transmissives allongées (2) délimitées par des régions opaques (3), l'appareil comprenant :
un système de rayonnement comprenant une source de rayonnement (LA) et un système d'illumination (IL) pour générer un faisceau d'illumination comprenant des particules chargées ;
une première table porte-objet mobile (MT) pourvue d'un porte-masque pour porter un masque ;
une deuxième table porte-objet mobile (WT) pourvue d'un porte-substrat pour porter un substrat ;
des moyens de positionnement pour balayer le masque et le substrat dans la direction longitudinale des régions transmissives au cours de la période d'exposition de ceux-ci ;
et
un système de projection (PL) pour reporter l'image de portions irradiées du masque sur des portions cibles du substrat ; **caractérisé en ce que** :
ledit système d'illumination est mis en oeuvre afin de générer un faisceau d'illumination ayant une largeur inférieure à la largeur de la région transmissive devant être illuminée,
et afin de balayer ledit faisceau d'illumination sur la largeur de ladite région transmissive une pluralité de fois au cours de la période d'exposition de manière à générer un profil d'intensité de faisceau trapézoïdal effectif.

2. Un procédé de fabrication d'un dispositif utilisant un appareil de projection lithographique afin de projeter une image d'un masque ayant une pluralité de régions transmissives allongées (2) délimitées par des régions opaques (3), l'appareil comprenant :
un système de rayonnement comprenant une source de rayonnement (LA) et une illumination (IL) pour générer un faisceau d'illumination ;
une première table porte-objet mobile (MT) pourvue d'un porte-masque pour porter un masque (M) ;
une deuxième table porte-objet mobile (WT) pourvue d'un porte-substrat pour porter un substrat (W) ;
des moyens de positionnement pour balayer le masque et le substrat dans la direction longitudinale des régions transmissives au cours de la période d'exposition de ceux-ci ;
un système de projection (PL) pour reporter l'image d'une de portions irradiées du masque sur des portions cibles du substrat pourvu d'une couche sensible à un rayonnement, de manière à ce qu'elles se chevauchent partiellement ; **caractérisé par** les étapes consistant à
générer un faisceau d'illumination ayant une largeur inférieure à la largeur de la région transmissive devant être illuminée ; et
balayer le faisceau d'illumination sur la largeur de ladite région transmissive au cours d'une période d'exposition de celle-ci tout en balayant le masque et le substrat dans la direction longitudinale de la région transmissive de manière à générer un profil d'intensité de faisceau trapézoïdal effectif.
